# EUROPEAN PATENT APPLICATION

(11) **EP 4 365 753 A1**
(43) Date of publication of application: **08.05.2024**
(21) Application number: 21951306.6
(22) Date of filing: 29.07.2021
(51) Int. Cl.: G06F 16/26, G06F 16/215, G06Q 50/06

(54) **METHOD AND APPARATUS FOR PRESENTING DATA INTEGRITY OF TRANSFORMER, AND STORAGE MEDIUM**

(71) Applicant: Siemens Aktiengesellschaft, 80333 München (DE)
(72) Inventor: WANG, Dan, Chengdu, 610000 (CN); LI, Jing, Beijing 100102 (CN); LIU, Hao, Beijing 100013 (CN); HUA, Wentao, Beijing 100102 (CN); ZHANG, Pengfei, Beijing 100102 (CN)
(74) Representative: Isarpatent
(86) International application number: PCT/CN2021/109333
(87) International publication number: WO 2023/004699

(57) **Abstract**

Disclosed in the embodiments of the present invention are a method and apparatus for presenting the data integrity of a transformer, and a storage medium. The method comprises: acquiring a data set, within a predetermined time period, of each of a plurality of transformers; generating a first graph of the plurality of transformers, wherein the first graph contains a first feature, which corresponds to each data point in each data set and is adapted to present the data integrity of each data point; and presenting the first graph. By means of the embodiments of the present invention, the data integrity of a transformer can be visually presented. The rule of data missing occurring in a plurality of transformers can also be discovered on the basis of a first graph, thereby facilitating a determination of data missing causes, and elimination of the fault of the transformers.

## Description

### Technical field

The present invention relates to the technical field of transformers, in particular to a method and apparatus for presenting data integrity of a transformer, and a storage medium.

### Background art

A transformer is an electrical device used for converting AC voltage/current and transmitting AC electrical energy. Transformers achieve the transfer of electrical energy according to the principle of electromagnetic induction. Transformers can be categorized, according to use, as power transformers, test transformers, instrumental transformers and special-use transformers, etc. Power transformers are necessary devices for power transmission/distribution and user power distribution; test transformers are devices for performing voltage tolerance (boost) tests on electrical equipment; instrumental transformers are used for electrical measurement and relay protection of power distribution systems; special-use transformers include smelting electric furnace transformers, electric welding transformers, electrolysis rectifier transformers, small voltage-regulating transformers, etc.

Transformers are regarded as one of the most important assets of the power industry. Data collected from transformers will be used for asset management. For various reasons, data loss often occurs in transformer measurement systems, and this will have an adverse impact on power load predictive analysis and evaluation of state of health, performed using data. Thus, before using transformer data for downstream analysis, it is generally necessary to evaluate the integrity of the data, otherwise the analysis results will be unreliable, and misleading results may even be produced.

However, data sets acquired by transformer collection are generally very large, and it will be challenging to produce a visually direct summary of data integrity. Moreover, when the data set is very large, it will be difficult to identify data patterns and determine the reasons behind the data patterns.

### Summary of the invention

Embodiments of the present invention propose a method and apparatus for presenting data integrity of a transformer, and a storage medium.

The technical solution of embodiments of the present invention is as follows:
A method for presenting data integrity of a transformer, the method comprising:
acquiring a data set of each of multiple transformers within a predetermined time period;
generating a first chart of the multiple transformers, the first chart containing a first feature which corresponds to each data point in each data set and is adapted to present the data integrity of said each data point;
presenting the first chart.

As can be seen, in embodiments of the present invention, the data integrity of multiple transformers can be displayed in a visually direct way by means of the first chart, making it easy to quickly ascertain the data integrity of each data point of multiple transformers, and thus facilitating downstream data evaluation.

In an embodiment, each data point in each data set has a respective ordered number pair (X, Y), wherein X is a data point number corresponding to a collection time of said each data point; Y is a transformer number of said each data point; and
within a 2D coordinate system with a horizontal axis representing data point numbers and a vertical axis representing transformer numbers, the position of the first feature of each data point in the first chart is determined on the basis of the ordered number pair (X, Y) of each data point.

Thus, in embodiments of the present invention, the position of the first feature of each data point in the first chart can be quickly determined on the basis of the mapping relationship of ordered number pairs in the 2D coordinate system, thus making it easy to generate the first chart quickly.

In an embodiment, the method further comprises:
determining the data point number on the basis of a collection date within the predetermined time period and a collection occasion within the collection date.

Thus, by further setting collection occasions within a collection date, the number of data points can be increased.

In an embodiment,
when data of a data point is complete, this corresponds to the first feature of the data point having a first color;
when data of a data point is incomplete, this corresponds to the first feature of the data point having a second color;
wherein the degree of contrast between the first color and the second color is greater than a predetermined threshold value.

As can be seen, displaying in different colors makes it easy to describe the data integrity of data points quickly in a visually direct way.

In an embodiment, the method further comprises:
selecting a single data set of a single transformer from the data sets of each of the multiple transformers;
generating a second chart of the single transformer, the second chart containing a second feature which corresponds to each data point in the single data set and is adapted to present the data integrity of said each data point; and
presenting the second chart.

Thus, in embodiments of the present invention, the data integrity of each transformer can be displayed in a visually direct way by means of the second chart, making it easy to quickly ascertain the data integrity of each data point of each transformer, and thus facilitating downstream data evaluation.

In an embodiment, each data point in the single data set has a respective ordered number pair (M, T), wherein M is a collection date number of said each data point; Y is a collection occasion number of said each data point within the collection date; and
within a 2D coordinate system with a horizontal axis representing collection date numbers and a vertical axis representing collection occasion numbers, the position in the second chart of the second feature of each data point in the single data set is determined on the basis of the ordered number pair (M, T) of each data point in the single data set.

As can be seen, in embodiments of the present invention, the position of the second feature of each data point in the second chart can be quickly determined on the basis of the mapping relationship of ordered number pairs in the 2D coordinate system, thus making it easy to generate the second chart quickly.

In an embodiment, the method further comprises:
determining a continuous region containing the second color in the first chart;
calculating a pixel area of the continuous region; and
issuing an alert indication when the pixel area of the continuous region is greater than a predetermined area threshold value and a shape of the continuous region meets a predetermined constraint condition.

Thus, a pattern of data deficiency occurring in multiple transformers can be determined in a visually direct way on the basis of the first chart, making it easy to determine the cause of the data deficiency, and facilitating transformer troubleshooting.

An apparatus for presenting data integrity of a transformer, comprising:
an acquisition module, for acquiring a data set of each of multiple transformers within a predetermined time period;
a generating module, for generating a first chart of the multiple transformers, the first chart containing a first feature which corresponds to each data point in each data set and is adapted to present the data integrity of said each data point;
a presenting module, for presenting the first chart.

As can be seen, in embodiments of the present invention, the data integrity of multiple transformers can be displayed in a visually direct way by means of the first chart, making it easy to quickly ascertain the data integrity of each data point of multiple transformers, and thus facilitating downstream data evaluation.

In an embodiment, each data point in each data set has a respective ordered number pair (X, Y), wherein X is a data point number corresponding to a collection time of said each data point; Y is a transformer number of said each data point; and
the generating module is used for: within a 2D coordinate system with a horizontal axis representing data point numbers and a vertical axis representing transformer numbers, determining the position of the first feature of each data point in the first chart on the basis of the ordered number pair (X, Y) of each data point.

Thus, in embodiments of the present invention, the position of the first feature of each data point in the first chart can be quickly determined on the basis of the mapping relationship of ordered number pairs in the 2D coordinate system, thus making it easy to generate the first chart quickly.

In an embodiment, the generating module is used for determining the data point number on the basis of a collection date within the predetermined time period and a collection occasion within the collection date.

Thus, by further setting collection occasions within a collection date, the number of data points can be increased.

In an embodiment, the apparatus is characterized in that
when data of a data point is complete, this corresponds to the first feature of the data point having a first color; when data of a data point is incomplete, this corresponds to the first feature of the data point having a second color, wherein the degree of contrast between the first color and the second color is greater than a predetermined threshold value.

As can be seen, displaying in different colors makes it easy to describe the data integrity of data points quickly in a visually direct way.

In an embodiment, the acquisition module is further used for selecting a single data set of a single transformer from the data sets of each of the multiple transformers; the generating module is further used for generating a second chart of the single transformer, the second chart containing a second feature which corresponds to each data point in the single data set and is adapted to present the data integrity of said each data point; and the presenting module is further used for presenting the second chart.

Thus, in embodiments of the present invention, the data integrity of each transformer can be displayed in a visually direct way by means of the second chart, making it easy to quickly ascertain the data integrity of each data point of each transformer, and thus facilitating downstream data evaluation.

In an embodiment, each data point in the single data set has a respective ordered number pair (M, T), wherein M is a collection date number of said each data point; Y is a collection occasion number of said each data point within the collection date; and
the generating module is further used for: within a 2D coordinate system with a horizontal axis representing collection date numbers and a vertical axis representing collection occasion numbers, determining the position in the second chart of the second feature of each data point in the single data set on the basis of the ordered number pair (M, T) of each data point in the single data set.

As can be seen, in embodiments of the present invention, the position of the second feature of each data point in the second chart can be quickly determined on the basis of the mapping relationship of ordered number pairs in the 2D coordinate system, thus making it easy to generate the second chart quickly.

In an embodiment, the apparatus further comprises: an alerting module, for determining a continuous region containing the second color in the first chart; calculating a pixel area of the continuous region; and issuing an alert indication when the pixel area of the continuous region is greater than a predetermined area threshold value and a shape of the continuous region meets a predetermined constraint condition.

Thus, a pattern of data deficiency occurring in multiple transformers can be determined in a visually direct way on the basis of the first chart, making it easy to determine the cause of the data deficiency, and facilitating transformer troubleshooting.

An apparatus for presenting transformer data integrity, comprising: a processor and a memory; wherein an application program executable by the processor is stored in the memory, and used for causing the processor to perform the method for presenting data integrity of a transformer as described in any of the embodiments above.

As can be seen, an apparatus with a processor-memory architecture for presenting transformer data integrity is proposed, and the data integrity of multiple transformers can be displayed in a visually direct way by means of the first chart, making it easy to quickly ascertain the data integrity of each data point of multiple transformers, and thus facilitating downstream data evaluation.

A computer-readable storage medium, having a computer-readable instruction stored therein, the computer-readable instruction being used to perform the method for presenting data integrity of a transformer as described in any of the embodiments above.

Thus, a computer-readable storage medium containing a computer-readable instruction is proposed, and the data integrity of multiple transformers can be displayed in a visually direct way by means of the first chart, making it easy to quickly ascertain the data integrity of each data point of multiple transformers, and thus facilitating downstream data evaluation.

### Brief description of the drawings

Fig. 1 is a flow chart of a method for presenting data integrity of a transformer in an embodiment of the present invention.
Fig. 2 is a demonstrative first chart of multiple transformers in an embodiment of the present invention.
Fig. 3 is a first demonstrative second chart of a single transformer in an embodiment of the present invention.
Fig. 4 is a second demonstrative second chart of a single transformer in an embodiment of the present invention.
Fig. 5 is a third demonstrative second chart of a single transformer in an embodiment of the present invention.
Fig. 6 is a block diagram of an apparatus for presenting data integrity of a transformer in an embodiment of the present invention.
Fig. 7 is a block diagram of an apparatus with a memory-processor architecture for presenting transformer data integrity in an embodiment of the present invention.

Key to the drawings:

| Label | Meaning |
|---|---|
| 100 | Method for presenting data integrity of transformer |
| 101-103 | Steps |
| 21 | First continuous region |
| 31 | Second continuous region |
| 600 | Apparatus for presenting data integrity of transformer |
| 601 | Acquisition module |
| 602 | Generating module |
| 603 | Presenting module |
| 604 | Alerting module |
| 700 | Apparatus for presenting data integrity of transformer |
| 701 | Processor |
| 702 | Memory |

### Detailed description of the invention

To clarify the technical solution and advantages of the present invention, the present invention is explained in further detail below in conjunction with the drawings and embodiments. It should be understood that the specific embodiments described here are merely used to explain the present invention illustratively, and not to limit the scope of protection thereof.

To make the description concise and intuitive, the solution of the present invention is expounded by describing some representative embodiments. The numerous details in the embodiments are merely intended to aid understanding of the solution of the present invention. However, it is obvious that when implemented, the technical solution of the present invention need not be limited to these details. To avoid obfuscating the solution of the present invention unnecessarily, some embodiments are not described in detail; instead, only an outline is given. Hereinbelow, "comprising" means "including but not limited to", and "according to..." means "at least according to..., but not limited to only according to...". When the quantity of a component is not specifically indicated hereinbelow due to the linguistic customs of Chinese, this means that the component may be one or more, or may be understood to be at least one.

Embodiments of the present invention propose a technical solution for presenting transformer data integrity. The data integrity of multiple transformers can be displayed in a visually direct way by displaying a first feature (e.g. color) corresponding to data integrity at a pixel point corresponding to a collection time of each data point.

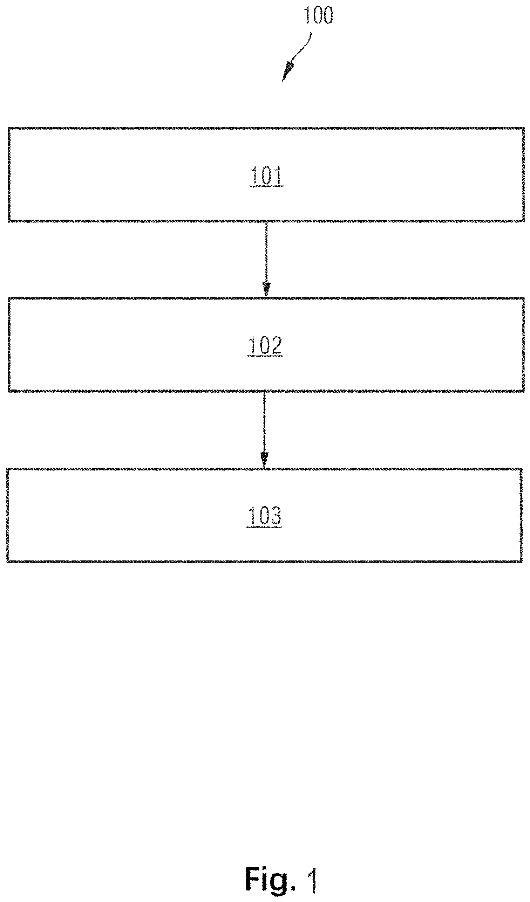

Fig. 1 is a flow chart of a method for presenting data integrity of a transformer in an embodiment of the present invention.

As shown in Fig. 1, the method 100 comprises:
Step 101: acquiring a data set of each of multiple transformers within a predetermined time period.

Here, real-time current values of the transformer can be read continuously from an ammeter (e.g. various high-voltage ammeters) of the transformer within a predetermined time period, to form a data set containing current data. Similarly, real-time voltage values of the transformer can be read continuously from a voltmeter (e.g. various high-voltage voltmeters) of the transformer within a predetermined time period, to form a data set containing varying voltage data. Optionally, a sensor may also be used directly to collect electrical attribute values (e.g. current data or voltage data) of the transformer, and form a data set containing the electrical attribute values.

In general, all of the data sets used to determine the data integrity of the transformers contain data points of the same electrical attribute, for example, they all contain current data or all contain voltage data.

Preferably, one data set of each transformer within a predetermined time period is acquired in step 101, for use in downstream processing of the present method. For example, supposing that there are N transformers, then data sets containing data of the same electrical attribute of each transformer within the same time period T are acquired, wherein one transformer corresponds to one data set, i.e. N data sets in total are acquired.

Step 102: generating a first chart of the multiple transformers, the first chart containing a first feature which corresponds to each data point in each data set and is adapted to present the data integrity of each data point.

Here, one first chart is generated for multiple transformers. The first chart can present the data integrity of each transformer in a 2D coordinate system. The first chart contains a first feature of each data point in each data set, wherein the first feature is adapted to present the data integrity of each data point.

In an embodiment, each data point in each data set has a respective ordered number pair (X, Y), wherein X is a data point number corresponding to a collection time of said each data point; Y is a transformer number of said each data point; and within a 2D coordinate system with a horizontal axis representing data point numbers and a vertical axis representing transformer numbers, the position of the first feature of each data point in the first chart is determined on the basis of the ordered number pair (X, Y) of each data point. As can be seen, in embodiments of the present invention, the position of the first feature of each data point in the first chart can be quickly determined on the basis of the mapping relationship of ordered number pairs in the 2D coordinate system, thus making it easy to generate the first chart quickly.

Preferably, the data point number is determined on the basis of a collection date within the predetermined time period and a collection occasion within the collection date. Thus, by further setting collection occasions within a collection date, the number of data points can be increased.

The first feature may be a color, or a shape.

When the first feature is a color feature:
(1) when the data of a data point is complete, this corresponds to the first feature of the data point having a first color;
(2) when the data of a data point is incomplete, this corresponds to the first feature of the data point having a second color; wherein the degree of contrast between the first color and the second color is greater than a predetermined threshold value.

For example, the first color is implemented as blue, and the second color is implemented as white.

When the first feature is a shape feature:
(1) when the data of a data point is complete, this corresponds to the first feature of the data point having a first shape;
(2) when the data of a data point is incomplete, this corresponds to the first feature of the data point having a second shape; wherein the degree of visual difference between the first shape and the second shape is greater than a predetermined threshold value.

For example, the first shape is implemented as a circle, and the second shape is implemented as a triangle.

Typical real examples of the first feature have been described demonstratively above, but those skilled in the art will realize that such a description is purely demonstrative and not intended to limit the scope of protection of embodiments of the present invention.

Step 103: presenting the first chart.

Thus, in embodiments of the present invention, the data integrity of multiple transformers can be displayed in a visually direct way by means of the first chart, making it easy to quickly ascertain the data integrity of each data point of multiple transformers, and thus facilitating downstream data evaluation.

In an embodiment, the method 100 further comprises: selecting a single data set of a single transformer from the data sets of each of the multiple transformers; generating a second chart of the single transformer, the second chart containing a second feature which corresponds to each data point in the single data set and is adapted to present the data integrity of said each data point; and presenting the second chart. The second chart can present the data integrity of the single transformer in a 2D coordinate system. Thus, in embodiments of the present invention, the data integrity of a single transformer can be displayed in a visually direct way by means of the second chart, making it easy to quickly ascertain the data integrity of each data point of the single transformer, and thus facilitating downstream data evaluation.

In an embodiment, each data point in the single data set has a respective ordered number pair (M, T), wherein M is a collection date number of said each data point; Y is a collection occasion number of said each data point within the collection date; and within a 2D coordinate system with a horizontal axis representing collection date numbers and a vertical axis representing collection occasion numbers, the position in the second chart of the second feature of each data point in the single data set is determined on the basis of the ordered number pair (M, T) of each data point in the single data set.

As can be seen, in embodiments of the present invention, the position of the second feature of each data point in the second chart can be quickly determined on the basis of the mapping relationship of ordered number pairs in the 2D coordinate system, thus making it easy to generate the second chart quickly.

Similarly, the second feature may be a color, or a shape. Preferably, the first feature is the same as the second feature, so that a user has the same judgment criteria when viewing the first chart and the second chart.

Specifically, when the second feature is a color feature:
(1) when the data of a data point is complete, this corresponds to the second feature of the data point having a first color;
(2) when the data of a data point is incomplete, this corresponds to the first feature of the data point having a second color; wherein the degree of contrast between the first color and the second color is greater than a predetermined threshold value.

For example, the first color is implemented as blue, and the second color is implemented as white.

When the second feature is a shape feature:
(1) when the data of a data point is complete, this corresponds to the second feature of the data point having a first shape;
(2) when the data of a data point is incomplete, this corresponds to the second feature of the data point having a second shape; wherein the degree of visual difference between the first shape and the second shape is greater than a predetermined threshold value.

For example, the first shape is implemented as a circle, and the second shape is implemented as a triangle.

Typical real examples of the second feature have been described demonstratively above, but those skilled in the art will realize that such a description is purely demonstrative and not intended to limit the scope of protection of embodiments of the present invention.

In an embodiment, the method further comprises: determining a continuous region containing the second color in the first chart; calculating a pixel area of the continuous region; and issuing an alert indication when the pixel area of the continuous region is greater than a predetermined area threshold value and a shape of the continuous region meets a predetermined constraint condition.

As can be seen, when the pixel area of the continuous region containing the second color is greater than the predetermined area threshold value, this means that a large number of transformers have experienced a data deficiency, or that a single transformer has experienced a data deficiency for a long time. In particular, when the constraint condition is a rectangle (with its short sides along the X axis), this means that multiple transformers have experienced a data deficiency within a short date, in which case, alert information that multiple transformers are simultaneously faulty and corresponding indication information (indicating for example that all of the transformers might have experienced a power outage) are issued. When the constraint condition is a rectangle (with its short sides along the Y axis), this means that a single transformer has experienced a data deficiency within a longer date, in which case, alert information alerting that the single transformer has been faulty for a long time and corresponding indication information (indicating for example that the single transformer might have experienced a fault) are issued.

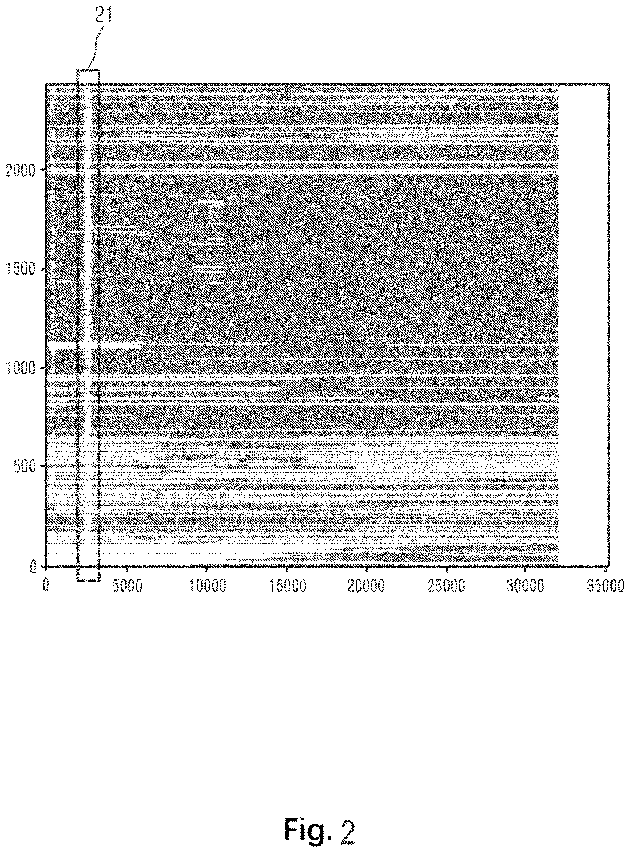

Fig. 2 is a demonstrative first chart of multiple transformers in an embodiment of the present invention. In Fig. 2, the horizontal axis represents data point numbers, and the vertical axis represents transformer numbers.

Suppose that there are 2400 transformers in total, a predetermined interval is 340 days, and there are 96 collection occasions evenly distributed in each day. Collection occasion 1 in one day corresponds to the earliest collection time of that day (e.g. 00:15), and collection occasion 96 in one day corresponds to the latest collection time of that day (e.g. 24:00). Thus, there are 340*96 = 32640 collection occasions in total in the predetermined interval. On each collection occasion, each transformer tries to acquire transformer data to form a respective data set. The data set of each transformer contains the data point acquired on each collection occasion, i.e. has 32640 data points.

Extending rightward on the horizontal axis from the origin, we sequentially pass through data point 1 (1^{st} collection occasion of day 1), data point 2 (2^{nd} collection occasion of day 1) ... data point 96 (96^{th} collection occasion of day 1), data point 97 (1^{st} collection occasion of day 2), data point 98 (2^{nd} collection occasion of day 2) ...data point 192 (96^{th} collection occasion of day 2) ...data point 193 (1^{st} collection occasion of day 3), data point 194 (2^{nd} collection occasion of day 3) ...data point 32545 (1^{st} collection occasion of day 340), data point 32546 (2^{nd} collection occasion of day 340), ...data point 32640 (96^{th} collection occasion of day 340). Extending upward on the vertical axis from the origin, we sequentially pass through the 1^{st} transformer, 2^{nd} transformer... until the 2400^{th} transformer.

In the first chart, the total number of pixel points is the number of transformers multiplied by the number of data points, i.e. there are 2400*32640 = 78,336,000 pixel points. Each pixel point corresponds to each data point (the horizontal coordinate of the pixel point corresponds to the data point number) of each transformer (the vertical coordinate of the pixel point corresponds to the transformer number) . Moreover, for each pixel point: when the data of the corresponding data point is complete, the pixel point presents a first color (e.g. blue); when the data of the data point is incomplete, the pixel point presents a second color (e.g. white).

In Fig. 2, a first continuous region 21 is a continuous region of the second color, and the area of the first continuous region 21 is large (whether the area of the first continuous region 21 is large may be determined on the basis of a result of comparison with an area threshold value) . It can be discovered by image recognition that the first continuous region 21 is a rectangle with its short sides along the horizontal axis, which means that each transformer has experienced a data deficiency within a short date (in Fig. 2, this roughly corresponds to the interval of the range of data point 2000 - data point 3000). In this case, alert information alerting that multiple transformers are simultaneously faulty and corresponding indication information (indicating for example that all of the transformers might have experienced a power outage within this interval, and reminding the user to inspect common power supply equipment of all of the transformers) are issued.

In Fig. 2, other continuous regions of the second color are also included. In this case, based on an alerting strategy that is set in advance, it is possible to choose to issue an alert or not issue an alert.

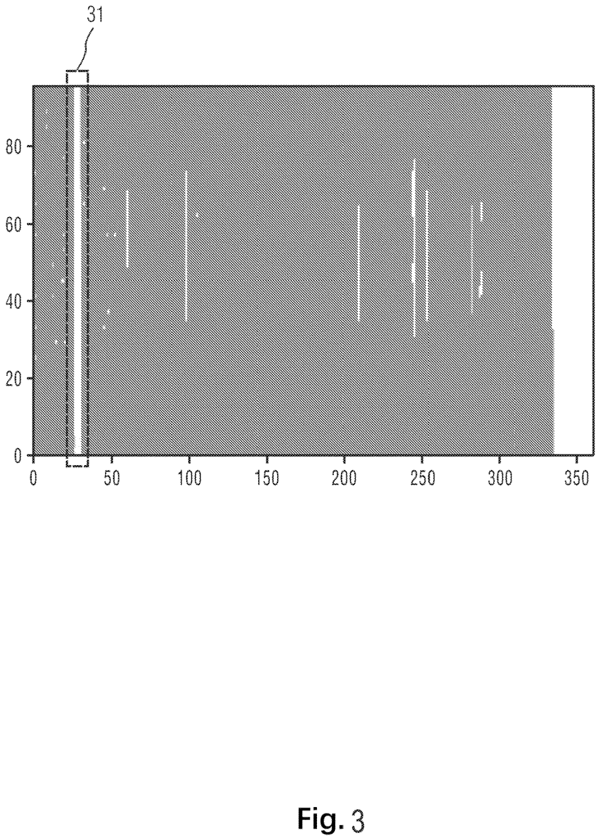

Fig. 3 is a first demonstrative second chart of a single transformer in an embodiment of the present invention. In Fig. 3, data integrity of the single transformer over 340 days is displayed. In Fig. 3, the horizontal axis represents the number of days, and the vertical axis represents the collection occasions within each day.

In the second chart shown in Fig. 3, the total number of pixel points is the number of days multiplied by the number of collection occasions, i.e. there are 340*96 = 32640 pixel points. Each pixel point corresponds to a data point (the horizontal coordinate of the pixel point corresponds to the collection occasion) of the single transformer on a particular day (the vertical coordinate of the pixel point corresponds to the number of days) . Moreover, for each pixel point: when the data of the corresponding data point is complete, the pixel point presents a first color (e.g. blue); when the data of the data point is incomplete, the pixel point presents a second color (e.g. white). Based on Fig. 3, the data integrity of a specific single transformer over 340 days can be displayed in a visually direct way.

In Fig. 3, a second continuous region 31 is a continuous region of the second color, and the area of the second continuous region 31 is large (whether the area of the first continuous region 21 is large may be determined on the basis of a result of comparison with an area threshold value) . As can be seen, the second continuous region 31 is a rectangle with its short sides along the horizontal axis, which means that the transformer has experienced a data deficiency on each collection occasion within a short date (in Fig. 2, this roughly corresponds to the interval of the range of date 20 - date 30). In this case, alert information alerting that the transformer has experienced a fault and corresponding indication information (indicating for example that the transformer has experienced a power outage or a fault within this time interval) are issued.

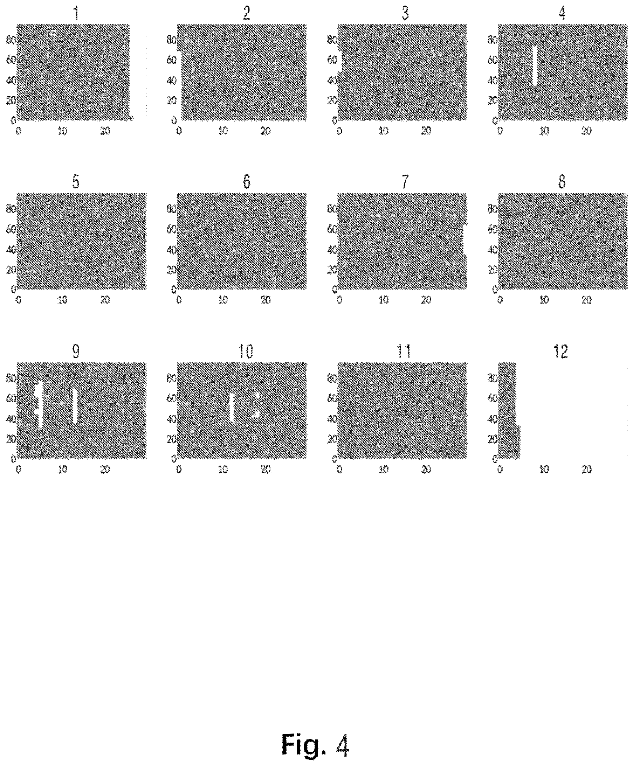

Fig. 4 is a second demonstrative second chart of a single transformer in an embodiment of the present invention. Fig. 4 comprises 12 sub-charts corresponding to 12 months, each sub-chart respectively displaying the data integrity of a single transformer over each corresponding month.

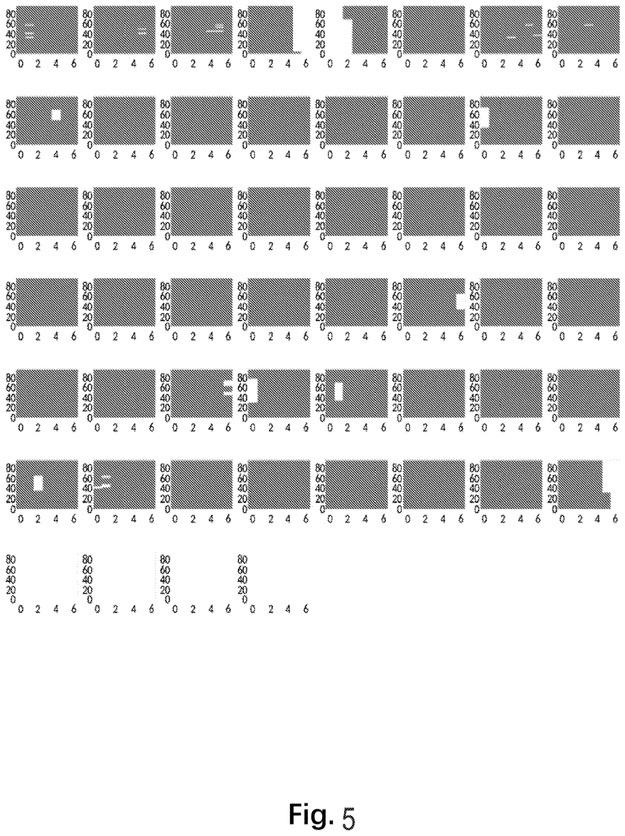

Fig. 5 is a third demonstrative second chart of a single transformer in an embodiment of the present invention. Fig. 5 comprises 52 sub-charts corresponding to 52 weeks, each sub-chart displaying the data integrity of a single transformer over each corresponding week. It can be seen from Fig. 5 that complete data deficiency occurred in the final five weeks.

Based on the above analysis, embodiments of the present invention further propose an apparatus for presenting data integrity of a transformer.

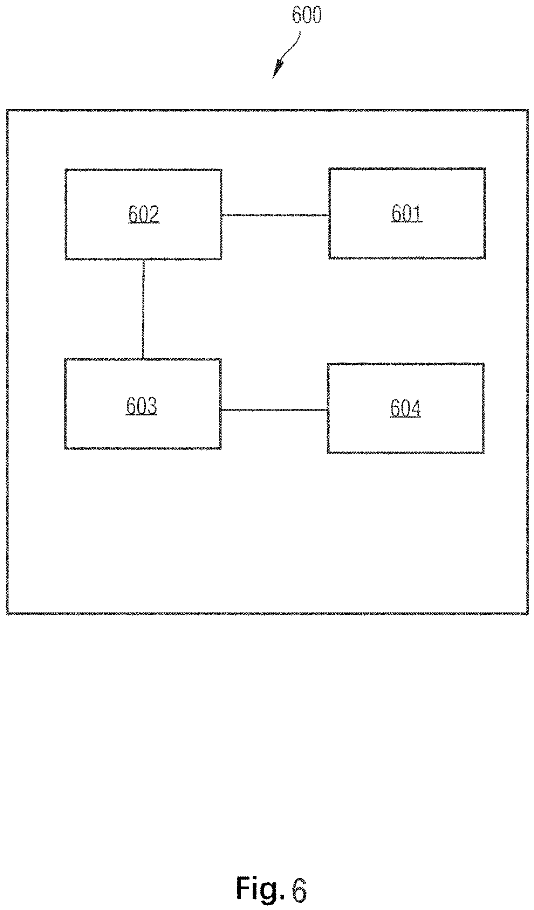

Fig. 6 is a structural drawing of an apparatus for presenting data integrity of a transformer in an embodiment of the present invention.

As shown in Fig. 6, the apparatus 600 comprises:
an acquisition module 601, for acquiring a data set of each of multiple transformers within a predetermined time period;
a generating module 602, for generating a first chart of the multiple transformers, the first chart containing a first feature which corresponds to each data point in each data set and is adapted to present the data integrity of said each data point;
a presenting module 603, for presenting the first chart.

In an embodiment, each data point in each data set has a respective ordered number pair (X, Y), wherein X is a data point number corresponding to a collection time of said each data point; Y is a transformer number of said each data point; and the generating module 602 is used for: within a 2D coordinate system with a horizontal axis representing data point numbers and a vertical axis representing transformer numbers, determining the position of the first feature of each data point in the first chart on the basis of the ordered number pair (X, Y) of each data point.

In an embodiment, the generating module 602 is used for determining the data point number on the basis of a collection date within the predetermined time period and a collection occasion within the collection date.

In an embodiment, when the data of a data point is complete, this corresponds to the first feature of the data point having a first color; when the data of a data point is incomplete, this corresponds to the first feature of the data point having a second color, wherein the degree of contrast between the first color and the second color is greater than a predetermined threshold value.

In an embodiment, the acquisition module 601 is further used for selecting a single data set of a single transformer from the data sets of each of the multiple transformers; the generating module 602 is further used for generating a second chart of the single transformer, the second chart containing a second feature which corresponds to each data point in the single data set and is adapted to present the data integrity of said each data point; and the presenting module 603 is further used for presenting the second chart.

In an embodiment, each data point in the single data set has a respective ordered number pair (M, T), wherein M is a collection date number of said each data point; Y is a collection occasion number of said each data point within the collection date; and the generating module 602 is further used for: within a 2D coordinate system with a horizontal axis representing collection date numbers and a vertical axis representing collection occasion numbers, determining the position in the second chart of the second feature of each data point in the single data set on the basis of the ordered number pair (M, T) of each data point in the single data set.

In an embodiment, the apparatus further comprises an alerting module 604, for determining a continuous region containing the second color in the first chart; calculating a pixel area of the continuous region; and issuing an alert indication when the pixel area of the continuous region is greater than a predetermined area threshold value and a shape of the continuous region meets a predetermined constraint condition.

Based on the description above, embodiments of the present invention further propose an apparatus with a memory-processor architecture for presenting transformer data integrity.

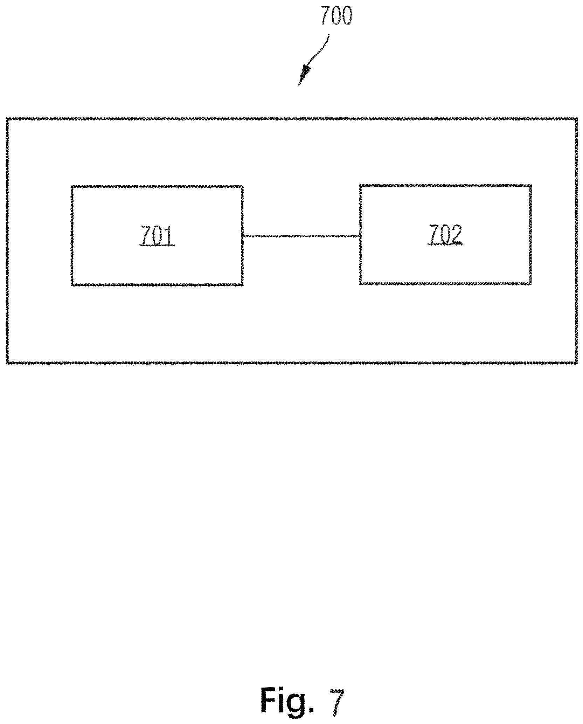

Fig. 7 is a block diagram of an apparatus with a memory-processor architecture for presenting transformer data integrity in an embodiment of the present invention.

As shown in Fig. 7, an apparatus 700 for presenting transformer data integrity comprises a processor 701, a memory 702, and a computer program stored on the memory 702 and capable of running on the processor 701, wherein the computer program, when executed by the processor 701, realizes any of the methods for presenting transformer data integrity described above.

The memory 702 may specifically be implemented as various storage media such as electrically erasable programmable read-only memory (EEPROM), flash memory and programmable read-only memory (PROM). The processor 701 may be implemented to comprise one or more central processor or one or more field programmable gate array, wherein the field programmable gate array integrates one or more central processor core. Specifically, the central processor or central processor core may be implemented as a CPU or MCU or DSP, etc.

It must be explained that not all of the steps and modules in the procedures and structural drawings above are necessary; certain steps or modules may be omitted according to actual needs. The order in which the steps are performed is not fixed, and may be adjusted as needed. The division of modules is merely functional division adopted to facilitate description; in practice, one module may be realized by multiple modules, and the functions of multiple modules may be realized by the same module, and these modules may be located in the same device or different devices.

Hardware modules in the embodiments may be realized mechanically or electronically. For example, a hardware module may include a specially designed permanent circuit or logic device (such as a dedicated processor, such as an FPGA or ASIC) for performing specific operations. A hardware module may also include a programmable logic device or circuit configured temporarily by software (e.g. including a general-purpose processor or another programmable processor) for performing specific operations. The decision to specifically use a mechanical method or a dedicated permanent circuit or a temporarily configured circuit (e.g. configured by software) to realize a hardware module may be made on the basis of cost and time considerations.

The present invention also provides a machine-readable storage medium, storing instructions for causing a machine to perform the method described herein. Specifically, a system or apparatus equipped with a storage medium may be provided, wherein software program code realizing the functions of any one of the above embodiments is stored on the storage medium, and a computer (or CPU or MPU) of the system or apparatus is caused to read and execute the program code stored in the storage medium. In addition, an operating system operating on a computer, etc. may be made to complete some or all of the actual operations by means of instructions based on program code. Program code read out from the storage medium may also be written into a memory installed in an expansion board inserted in the computer, or written into a memory installed in an expansion unit connected to the computer, and thereafter instructions based on the program code make a CPU etc. installed on the expansion board or expansion unit execute some or all of the actual operations, so as to realize the functions of any of the embodiments above. Embodiments of storage media used to provide program code include floppy disks, hard disks, magneto-optical disks, optical disks (e.g. CD-ROM, CD-R, CD-RW, DVD-ROM, DVD-RAM, DVD-RW, DVD+RW), magnetic tape, non-volatile memory cards and ROM. Optionally, program code may be downloaded from a server computer or cloud via a communication network.

The above are merely preferred embodiments of the present invention, which are not intended to limit the scope of protection thereof. Any amendments, equivalent substitutions or improvements, etc. made within the spirit and principles of the present invention should be included in the scope of protection thereof.

## Claims

1. A method (100) for presenting data integrity of a transformer, **characterized in that** the method (100) comprises:
acquiring a data set of each of multiple transformers within a predetermined time period (101);
generating a first chart of the multiple transformers, the first chart containing a first feature which corresponds to each data point in each data set and is adapted to present the data integrity of said each data point (102);
presenting the first chart (103).

2. The method (100) for presenting data integrity of a transformer as claimed in claim 1, **characterized in that** each data point in each data set has a respective ordered number pair (X, Y), wherein X is a data point number corresponding to a collection time of said each data point; Y is a transformer number of said each data point; and
within a 2D coordinate system with a horizontal axis representing data point numbers and a vertical axis representing transformer numbers, the position of the first feature of each data point in the first chart is determined on the basis of the ordered number pair (X, Y) of each data point.

3. The method (100) for presenting data integrity of a transformer as claimed in claim 2, **characterized by** further comprising:
determining the data point number on the basis of a collection date within the predetermined time period and a collection occasion within the collection date.

4. The method (100) for presenting data integrity of a transformer as claimed in any one of claims 1 - 3, **characterized in that**
when data of a data point is complete, this corresponds to the first feature of the data point having a first color;
when data of a data point is incomplete, this corresponds to the first feature of the data point having a second color;
wherein the degree of contrast between the first color and the second color is greater than a predetermined threshold value.

5. The method (100) for presenting data integrity of a transformer as claimed in claim 1, **characterized by** further comprising:
selecting a single data set of a single transformer from the data sets of each of the multiple transformers;
generating a second chart of the single transformer, the second chart containing a second feature which corresponds to each data point in the single data set and is adapted to present the data integrity of said each data point; and
presenting the second chart.

6. The method (100) for presenting data integrity of a transformer as claimed in claim 5, **characterized in that** each data point in the single data set has a respective ordered number pair (M, T), wherein M is a collection date number of said each data point; Y is a collection occasion number of said each data point within the collection date; and
within a 2D coordinate system with a horizontal axis representing collection date numbers and a vertical axis representing collection occasion numbers, the position in the second chart of the second feature of each data point in the single data set is determined on the basis of the ordered number pair (M, T) of each data point in the single data set.

7. The method (100) for presenting data integrity of a transformer as claimed in claim 4, **characterized by** further comprising:
determining a continuous region containing the second color in the first chart;
calculating a pixel area of the continuous region; and
issuing an alert indication when the pixel area of the continuous region is greater than a predetermined area threshold value and a shape of the continuous region meets a predetermined constraint condition.

8. An apparatus (600) for presenting data integrity of a transformer, **characterized by** comprising:
an acquisition module (601), for acquiring a data set of each of multiple transformers within a predetermined time period;
a generating module (602), for generating a first chart of the multiple transformers, the first chart containing a first feature which corresponds to each data point in each data set and is adapted to present the data integrity of said each data point;
a presenting module (603), for presenting the first chart.

9. The apparatus (600) for presenting data integrity of a transformer as claimed in claim 8, **characterized in that** each data point in each data set has a respective ordered number pair (X, Y), wherein X is a data point number corresponding to a collection time of said each data point; Y is a transformer number of said each data point; and
the generating module (602) is used for: within a 2D coordinate system with a horizontal axis representing data point numbers and a vertical axis representing transformer numbers, determining the position of the first feature of each data point in the first chart on the basis of the ordered number pair (X, Y) of each data point.

10. The apparatus (600) for presenting data integrity of a transformer as claimed in claim 9, **characterized in that**
the generating module (602) is used for determining the data point number on the basis of a collection date within the predetermined time period and a collection occasion within the collection date.

11. The apparatus (600) for presenting data integrity of a transformer as claimed in any one of claims 8 - 10, **characterized in that**
when data of a data point is complete, this corresponds to the first feature of the data point having a first color; when data of a data point is incomplete, this corresponds to the first feature of the data point having a second color, wherein the degree of contrast between the first color and the second color is greater than a predetermined threshold value.

12. The apparatus (600) for presenting data integrity of a transformer as claimed in claim 8, **characterized in that**
the acquisition module (601) is further used for selecting a single data set of a single transformer from the data sets of each of the multiple transformers;
the generating module (602) is further used for generating a second chart of the single transformer, the second chart containing a second feature which corresponds to each data point in the single data set and is adapted to present the data integrity of said each data point; and
the presenting module (603) is further used for presenting the second chart.

13. The apparatus (600) for presenting data integrity of a transformer as claimed in claim 12, **characterized in that** each data point in the single data set has a respective ordered number pair (M, T), wherein M is a collection date number of said each data point; Y is a collection occasion number of said each data point within the collection date; and
the generating module (602) is further used for: within a 2D coordinate system with a horizontal axis representing collection date numbers and a vertical axis representing collection occasion numbers, determining the position in the second chart of the second feature of each data point in the single data set on the basis of the ordered number pair (M, T) of each data point in the single data set.

14. The apparatus (600) for presenting data integrity of a transformer as claimed in claim 11, **characterized by** further comprising:
an alerting module (604), for determining a continuous region containing the second color in the first chart; calculating a pixel area of the continuous region; and issuing an alert indication when the pixel area of the continuous region is greater than a predetermined area threshold value and a shape of the continuous region meets a predetermined constraint condition.

15. An apparatus (700) for presenting transformer data integrity, **characterized by** comprising: a processor (701) and a memory (702);
wherein an application program executable by the processor (701) is stored in the memory (702), and used for causing the processor (701) to perform the method (100) for presenting data integrity of a transformer as claimed in any one of claims 1 - 7.

16. A computer-readable storage medium, **characterized by** having a computer-readable instruction stored therein, the computer-readable instruction being used to perform the method (100) for presenting data integrity of a transformer as claimed in any one of claims 1 - 7.
